# EUROPEAN PATENT APPLICATION

(11) **EP 4 246 741 A1**
(43) Date of publication of application: **20.09.2023**
(21) Application number: 22162017.2
(22) Date of filing: 15.03.2022
(51) Int. Cl.: H01S 5/187, H01S 5/34, H01S 5/028, H01S 5/12

(54) **VERTICAL EMISSION CASCADE LASERS**

(71) Applicant: Sensirion AG, 8712 Stäfa (CH)
(72) Inventor: Jouy, Pierre, 8712 Stäfa (CH)
(74) Representative: Keilitz Haines & Partner Patentanwälte PartGmbB

(57) **Abstract**

A vertical emission cascade laser (10) comprising an in-plane waveguide formed by a lower cladding layer (14), active region layers (15) and an upper cladding layer (16). A disk-shaped side surface (33) laterally bounds the in-plane waveguide and has a mirror layer (39) arranged over it to form a cavity capable of supporting multiple radial modes. An in-plane grating structure (28; 28, 29) of concentric rings is formed in one of the cladding layers (14, 16), the grating structure functioning both to select one of the multiple radial cavity modes for lasing and also to couple out the laser light through the lower and/or upper cladding layer (14, 16). The grating structure includes at least a higher order grating portion of order *m ≥ 2* and optionally also a first order grating portion with *m* = 1.

## Description

### BACKGROUND OF THE INVENTION

The invention relates to vertical emission cascade lasers.

Cascade laser is a generic term for quantum cascade laser (QCL) and interband cascade laser (ICL), wherein the former is based on cascading intraband transitions between subbands of quantum wells in a Type I superlattice structure, whereas the latter is based on cascading interband transitions between subbands of quantum wells in a Type II (or sometimes Type I) superlattice structure. Cascade lasers emit in the infrared, with QCLs having been demonstrated with emission wavelengths from 2.6 µm up to 250 µm. QCLs are in much more widespread use than ICLs, so the following summary of the prior art is exclusively concerned with QCLs.

Most QCLs, including perhaps all commercially available devices, are based on an edge-emitting structure similar to the structure of a standard edge-emitting laser diode. In an edge-emitting laser diode the laser emission is lateral in relation to the semiconductor heterostructure stack. An opposed pair of cleaved facets form a Fabry-Perot cavity familiar from general laser resonator design. One cleaved facet acts as a back reflector and the other as an output coupler. Without other measures, an edge-emitting laser diode will have multimode emission. One way to provide single-mode emission is to fabricate an in-plane grating along the waveguiding layer, such lasers being called distributed feedback (DFB) lasers. Another way to provide single-mode emission is to provide an in-plane grating at one end of the waveguiding layer to provide a back reflector, such a mirror being called a distributed Bragg reflector (DBR) and the laser a DBR laser. External cavity designs are also well known in which one or both the facet surfaces are made non-reflective, so that the semiconductor chip then acts solely as a gain medium, i.e. like a rod in an old-style laser resonator design such as ruby or Ti:sapphire. QCLs are known that follow these edge-emitting diode laser design features in a one-to-one analogy, i.e. cleaved facet reflector QCLs, DFB QCLs, DBR QCLs, and external cavity QCLs.

Another common type of semiconductor laser diode is the vertical cavity surface emitting laser (VCSEL), where emission takes place in the growth direction of the stack, i.e. perpendicular to the plane of the heterostructure layers, most commonly from the top surface. A VCSEL has a resonator design in which top and bottom mirrors (output coupler and back reflector) for forming a Fabry-Perot cavity are fabricated as DBRs, e.g. with alternating layers of GaAs and GaAIAs. Namely, a superlattice stack of layers is grown to form a Bragg reflector for each mirror, the two Bragg reflectors being arranged either side of the active layers in the layer stack. A standard VCSEL emits through the top of the stack, but some special designs emit through the bottom, i.e. through the substrate, these being referred to as bottom-emitting VCSELs (even though they are not surface emitting as such).

As mentioned above, commercially available QCLs are based on an edge-emitting laser diode structure. It would in principle be desirable, if it were possible to fabricate QCLs in a vertical emission configuration. It could be expected that vertically emitting QCLs might have similar advantages to those enjoyed by VCSELs over edge-emitting laser diodes, such as lower beam divergence, better far-field beam quality, the ability to fabricate more devices per wafer, the ability to perform *in situ* testing of laser function on the wafer during fabrication, no high-quality cleaving needed, and the possibility of combining multiple adjacent lasers into a monolithic laser array device. However, a conventional VCSEL geometry using DBRs cannot be used for a QCL. This is because polarization selection rules in a QCL mean that intraband transitions involving vertically travelling photons provide no gain. A straightforward implementation of a vertically emitting QCL in one-to-one analogy with a VCSEL design is therefore not possible. The electric field of the light generated in a QCL is always polarized in the growth direction, so only gain in the TM mode is possible.

As summarized briefly below, several vertical emission QCL designs have been proposed in the literature which avoid this limitation by using an in-plane waveguide mode for lasing combined with a second order grating to couple out a portion of the laser radiation vertically.

Süess *et al* 2016 [1] discloses a vertically emitting QCL based on a linear ridge waveguide. End mirrors are formed by respective first order grating DBR structures fabricated at each end of the ridge waveguide, the periodicity of the first order gratings also providing mode selection. In addition, for vertical outcoupling, a second order grating is fabricated in the manner of a DFB structure on top of the ridge waveguide. The second order grating refracts a portion of the light from the lasing mode out of the waveguide in the vertical direction to provide for vertical outcoupling and so emission from the top surface of the chip.

Szedlak *et al* 2014 [2] discloses a vertically emitting QCL in the form of a ring laser in which a circular ridge waveguide forms a ring. The waveguide mode exploited for gain and laser action is selected by a second order DFB grating fabricated on top of the ring that also serves as an outcoupling element that refracts the light in vertical direction and thus allows for vertical outcoupling from the waveguide and so emission from the top surface of the chip. The grating "lines" are thus radially extending at equal angular offsets with respect to the circle defined by the ring.

Mahler *et al* 2009 [3] discloses a vertically emitting QCL in the form of a microdisk laser based on a cylindrical waveguide. A microdisk laser is a special type of resonator in which the waveguide mode exploited for gain and laser action is a whispering gallery mode, i.e. a mode created by total internal reflections of photons travelling around the perimeter of the disk.

Liang *et al* 2013 [4] discloses a vertically emitting QCL emitting at about 80 micrometers (3.73 THz). The active region is formed by a GaAs/GaAIAs heterostructure. A concentric circular grating (CCG) is formed by metal rings on the surface of the semiconductor heterostructure. The CCG selects an azimuthal mode for lasing, i.e. a waveguiding mode that propagates angularly around the ring structure. The concentric rings have angular breaks at 120 degree intervals to form a three-spoked bridge structure that allows the grating to be electrically pumped to excite the desired azimuthal mode.

US 2019/074663 A1 from Toshiba [5] discloses a vertically emitting QCL based on a two-dimensional photonic crystal in a square format. The active region is formed by an InGaAs/InAlAs multi-quantum well heterostructure. A square first order grating DBR is arranged around the edges of the active region layers and a second order square grating is arranged centrally to perform the vertical out-coupling.

### SUMMARY OF THE INVENTION

According to one aspect of the invention, there is provided a cascade laser configured to emit laser light at a lasing wavelength, A, the cascade laser comprising:
an in-plane waveguide formed by a semiconductor layer stack comprising in sequence a lower cladding layer, a plurality of active region layers to provide gain and an upper cladding layer, the in-plane waveguide being bounded laterally into a disk shape by a side surface;
a mirror layer arranged over the disk-shaped side surface, the mirror layer being shaped and dimensioned to form a cavity for the in-plane waveguide which supports multiple radial modes; and
a grating structure of concentric rings formed in one of the upper and lower cladding layers, the grating structure including at least a higher order grating portion of order *m ≥* 2 and serving both to select at least one of the multiple radial modes for lasing and to couple out the laser light through at least one of the lower and upper cladding layers.

According to another aspect of the invention, there is provided a method of manufacturing a cascade laser configured to emit laser light at a lasing wavelength, A, the method comprising:
forming an epitaxial semiconductor layer structure comprising in sequence a lower cladding layer, a plurality of active region layers to provide gain and an upper cladding layer, which layers collectively form an in-plane waveguide;
defining with an etch process a disk-shaped side surface which laterally bounds the in-plane waveguide;
depositing a mirror layer over the disk-shaped side surface, the mirror layer and disk-shaped side surface being shaped and dimensioned to form a cavity for the in-plane waveguide which supports multiple radial modes; and
forming a grating structure of concentric rings in one of the upper and lower cladding layers, the grating structure including at least a higher order grating portion of order *m ≥* 2 and serving both to select at least one of the multiple radial modes for lasing and to couple out the laser light through at least one of the lower and upper cladding layers.

In some embodiments, the radial mode selection by the grating structure is such that only one of the multiple radial modes is capable of attaining lasing threshold, thereby to provide single mode laser output. Single mode operation will be the normally desired situation. However, the grating design might allow for competition between two or more of the multiple radial modes for lasing, especially at higher laser drive currents.

The grating structure may be formed of a single set of concentric rings. Alternatively, there may be two or more sets of concentric rings so that the grating structure is subdivided into multiple concentric subelements, each separated by a radial gap arranged between adjacent concentric subelements. The or each radial gap may have a radial extent equal to at least 2·λ / *n.* The radial gap provides a gain section in the plane of the in-plane waveguide.

In most embodiments, the concentric rings of the grating structure will be circular. However, it may be that the concentric rings could be slightly oval, e.g. elliptical, to favor outcoupling of a certain polarization. Another possibility is to form the grating structure from concentric polygons, e.g. concentric octagons, decagons, dodecagons etc. In that case, the mirror layer and disk-shaped side surface would be similarly shaped as an oval or a polygon to be concentric with the oval or polygonal grating structure.

The higher order grating portion couples out a component of the lasing radial mode from the active region layers through one (or both) of the lower and upper cladding layers as the laser light. The higher order grating portion also makes a mode selection among the multiple radial modes supported by the in-plane waveguide.

In some embodiments, the higher order grating is of order *m* = 2, i.e. a second order grating. In other embodiments, the higher order grating may be of order *m* = 3, 4 or more. By 'higher order' in this document we mean *m ≥* 2.

In some embodiments, the grating structure additionally includes a first order grating portion, i.e. with *m* = *1*. The first order grating portion reinforces the mode selection effect of the grating structure. The first order grating portion may be formed of concentric rings that are co-concentric with concentric rings of the higher order grating. The first order grating has a radial periodicity of Λ = λ / 2*·n.* The first and higher order gratings thus have matched periodicities. If there is both a higher order grating and a first order grating, then both collectively define the lasing, radial mode. If there is no first order grating, i.e. only a higher order grating, then which radial mode is selected for lasing is solely defined by the higher (e.g. second) order grating.

Combining a first order grating with the higher order grating is useful, since the first order grating does not contribute to the surface outcoupling but does contribute to the mode selection among the multiple radial modes supported by the cavity, whereas the higher order grating contributes to both whether the order is even, e.g. 2, 4, or odd, e.g. 3, 5. Having a first order grating portion as well as a higher order grating portion thus provides more design freedom. The design of the higher order grating portion can be optimized solely with its outcoupling function in mind and without regard to its efficiency as a mode selector to pick out which of the multiple radial modes supported by the cavity formed by the mirror layer will attain lasing threshold. The strength of the mode selection function of the grating structure can then primarily be fulfilled by the first order grating portion, even though the higher order grating portion will inherently also contribute to the mode selection, since it also complies with the same periodicity formula as stated above. The design of the first order grating portion for mode selection is easier than for the higher order grating portion, since diffraction by the first order grating portion will primarily be zeroth order, i.e. back reflection, which is not associated with losses from the cavity in the same way as the higher order grating portions.

However, in other embodiments, the grating structure consists solely of the higher order grating portion which is therefore required to perform both the function of coupling out the laser light through at least one of the lower and upper cladding layers and the function of selecting among the multiple radial modes for lasing.

In some embodiments, the mirror layer provides a reflectivity of at least one of 90%, 91%, 92%, 93%, 94% and 95% at the lasing wavelength. In some embodiments, a dielectric layer of a dielectric material is arranged between the disk-shaped side surface of the semiconductor stack and the mirror layer. The dielectric layer preferably has a thickness that approximates to a quarter of the lasing wavelength within the dielectric material, namely a thickness in the range 0.1 to 0.5 · *k* · *λ*/*n_{d}* , more particularly 0.2 to 0.3 · *k* · *λ*/*n_{d},* where *k* = 1, 3, 5, 7 .... and *n_{d}* is the refractive index of the dielectric material at the lasing wavelength. Providing a dielectric layer of this kind can increase reflectivity. Namely, the mirror layer and the dielectric layer may cooperate to provide a reflectivity of at least one of 96%, 97%, 98% and 99% at the lasing wavelength.

By way of example, the dielectric material may be one of Si₃N₄, Al₂O₃, SiO₂, InP (semiinsulating), YF₃, Y₂O₃ and Ge (insulating). By way of example, the mirror layer may be formed of a metal, specifically one of: Au, Ag, Pt, Al, Cu or an alloy of two or more of these metals. The mirror layer may also be formed of a semiconductor layer deposited on the disk-shaped side surface. One example combination of dielectric and metal is Si₃N₄ / Au, which would be suitable for laser wavelengths up to 5 µm. Another example combination is SiO₂ / Au, which would be suitable for laser wavelengths up to about 7 µm. Another example combination is Al₂O₃ / Au, which could be used for longer lasing wavelengths, e.g. greater than 5 µm.

Optionally, an additional adhesion layer may be applied on the dielectric material before depositing the metal, i.e. may be arranged between the dielectric layer and the metal layer. The adhesion layer may have a thickness of only a few nanometres. The adhesion layer may be of Ti.

It is beneficial if the thickness of the dielectric layer is made to be at least approximately equal to an odd integer multiple of one quarter of the lasing wavelength (in the dielectric material), i.e. *k*·λ/4, where *k* = 1, 3, 5, 7 etc., since this minimizes absorption due to Ohmic losses at the dielectric-metal or dielectric-semiconductor boundary. Satisfying the odd quarter-wavelength condition forces a node boundary condition on the dielectric-metal or dielectric-semiconductor interface so that the metal mirror layer and the dielectric layer cooperate to provide a reflectivity higher than the intrinsic reflectivity of the metal alone. An example λ/4 thickness, i.e. *k* = 1, for the dielectric layer is approximately 525 nm in Si₃N₄ for a lasing wavelength of 4 µm where the refractive index of Si₃N₄ at 4 µm is taken as *n* = 1.9. Another example is 680 nm in Al₂O₃ for a lasing wavelength of 4.5 µm where the refractive index of Al₂O₃ at 4.5 µm is taken as *n* = 1.65. (The wavelength of light in a medium of refractive index *n* is reduced by λ *l n* compared with its value in vacuum.) The metal mirror layer should be sufficiently thick to provide its maximum reflectivity, i.e. substantially thicker than the skin depth of light at the lasing wavelength in the metal. A thickness of the metal layer of a few tens of nanometers will be sufficient in most cases. One example metal thickness is 200 nm of Au. It is further noted that although in principle the reflectivity of the metal mirror layer is wavelength dependent, since the cascade laser will have a relatively narrow gain bandwidth, the reflectivity of the metal mirror layer will in practice be essentially constant in respect of the laser's operation.

The dielectric material not only provides an optical function for increasing the reflectivity from the metal mirror layer but also, since the dielectric material is electrically insulating, it electrically isolates the metal mirror layer from the rest of the semiconductor layer stack and the current injection electrodes, so the metal of the mirror layer does not disrupt the electrical performance of the device.

Typically, the cascade laser will have a lasing wavelength in the wavelength range 2 to 20 micrometers.

In some embodiments, the concentric rings of the grating structure on the one hand and the disk-shaped side surface on the other hand are at least approximately concentric with each other.

In some embodiments, the grating structure is formed by a refractive index contrast in a horizontal plane between portions of the upper or lower cladding layer in which it is formed and one of an adjacent: metal layer; degenerately doped semiconductor layer; air; dielectric material; and further layer of semiconductor material. The further layer may be arranged at an interface of, or embedded within, the upper cladding layer.

To form a quantum cascade laser, the plurality of active region layers form a superlattice structure configured to provide gain through intraband transitions between quantum well subbands. The in-plane waveguiding action can be provided by refractive index contrast in the vertical direction between lower refractive index, lower and upper cladding layers, and a higher refractive index, active region. In-plane waveguiding confinement for the lasing mode(s) is therefore provided with sufficient overlap in the vertical direction with the gain medium of the active region.

To form an interband cascade laser, the plurality of active region layers form a superlattice structure configured to provide gain through interband transitions between quantum well subbands. The in-plane waveguiding action can be provided, for example, by refractive index contrast in the vertical direction between lower refractive index, lower and upper cladding layers and higher refractive index, lower and upper separate confinement layers and active region. In other words, the lower separate confinement layers are arranged between the active region and the lower cladding layer, and the upper separate confinement layers are arranged between the active region and the upper cladding layer. In-plane waveguiding confinement for the lasing mode(s) is therefore provided with sufficient overlap in the vertical direction with the gain medium of the active region.

To drive the laser, first and second electrodes can be arranged to apply a voltage bias across the active region layers for current injection.

In some embodiments the laser light is coupled out downwards through the lower cladding layer. In other embodiments, the laser light is coupled out upwards through the upper cladding layer. In this case, a top electrode arranged over the upper cladding layer can be provided with an aperture to allow free passage of the laser light out of the laser. Alternatively, the top electrode could be transparent or semi-transparent, e.g. made of a thin layer of Au.

The semiconductor stack may be arranged on a suitable substrate that supports the semiconductor layers of the active region layers and the surrounding lower and upper cladding layers. In some embodiments, the lower cladding layer may be an integral part of the substrate.

In some embodiments, the layers of the semiconductor layer stack are collectively configured so that the in-plane waveguide has a lower loss and/or higher gain central region and a higher loss and/or lower gain peripheral region in order to suppress propagation of unwanted waveguiding modes, such as whispering gallery modes, that might otherwise establish themselves in the peripheral region of the in-plane waveguide.

The disk-shaped side surface will typically be formed by dry etching, such as reactive ion etching.

The disk-shaped side surface will be cylindrical in shape if the etch is vertical. However, in practice a precisely vertical etch may be difficult to achieve, so the etch surface may have a tilt angle away from vertical. With a non-vertical, i.e. tilted, sidewall, the disk-shaped side surface will have a frustum shape. With a non-vertical sidewall and a surface with circular rotational symmetry, the frustum will be a conical frustum. This angle may be up to 20 degrees but is preferably less than 15, 10 or 5 degrees. A tilt angle can be tolerated so long as the tilt angle is not so large as to cause back reflected light to be lost to the waveguide. In other words, if the tilt angle is not too large, back reflected portions of radial modes will still be retained in, i.e. guided by, the in-plane waveguide. From a simplistic geometric optics point of view, a tilt angle away from vertical of up to 90 minus the critical angle of the waveguide can be tolerated.

The semiconductor layers will be grown epitaxially in sequence on a suitable substrate, the substrate thus supporting the semiconductor layers. In some instances, it may be beneficial to remove part or all of the substrate after growth, for example with a lapping and selective etching process, so the original substrate at the time of growth may not be present in the final device.

By using a radial mode as the optical mode for lasing, a good overlap between the lasing optical mode and the gain medium can be provided in a relatively small wafer area. In particular, the overlap between a radial mode and the gain medium can be made larger than is possible for whispering gallery modes in microdisks. Moreover, a radial mode design can generally provide a smaller area device compared with a ring laser.

It is noted that generally for a linear grating, the periodicity, Λ, is given by Λ = *m*·λ / 2·*n*, where *n* is the effective refractive index for the radial mode and *m* is a positive integer defining the grating order. However, with a concentric circular grating (CCG), the theoretically ideal periodicity does not exactly follow the linear grating formula, but deviates somewhat following a Bessel distribution. Nevertheless, for simplicity in this document we use the linear grating formula to express CCG periodicity on the understanding that a Bessel distribution is meant. Still further, it may be that deviations from a Bessel distribution can be used as a design parameter, e.g. for beam shaping or for controlling cavity losses. The effective refractive index for the radial mode is the net refractive index that is experienced by the radial mode taking account of its vertical distribution through multiple layers of the semiconductor heterostructure which will in general each have different refractive index values. The effective refractive index will also be affected by any in-plane variation of refractive index that may exist. These comments on grating periodicity are applicable to both the higher order grating and the optional first order grating.

It may be beneficial to provide a radial gap in between concentric subelements of the first and/or second order grating and/or between the first order grating and the higher order grating. The radial gap(s) have a radial extent equal to at least 2·λ / *n* and provide an in-plane gain section. The radial mode can therefore experience gain over the gain section without co-action of a grating. The radial extent of the gain section may be equal to at least several times the periodicity of the first order grating, for example, at least 2·λ / *n,* 3·λ / *n,* 4·λ / *n,* 5·λ / *n* or 10·λ / *n.* In some embodiments, the first order grating and/or the higher order grating may be subdivided into multiple subelements covering different ranges of radial extension, in which case there may be multiple radial gaps between the different subelements. If both a first order grating and a higher order grating are included, then these subelements may be radially interleaved with or without radial gaps between the subelements.

The higher order grating may incorporate a phase shift, such as a π-shift, to affect the output beam profile. Moreover, in embodiments that include a first order grating, the first order grating may incorporate a phase-shift, such as a π-shift.

The grating structures for the higher order grating and optional first order grating may be formed by suitable lithography steps, in particular photolithography, optionally in combination with semiconductor overgrowth. These steps may involve etching, for example with wet or dry etching processes.

After growth of the semiconductor heterostructure, suitable electrodes are formed to allow for carrier injection into the active region. Typically, these will be formed by a suitable metal or metals, e.g. by depositing Au and Ti layers. However, other suitably conductive materials may be used, such as degeneratively doped semiconductors, as may be easy to do with the narrowband semiconductor materials used for ICLs. A pair of electrodes are jointly arranged to apply a voltage bias across the active region for current injection. Both electrodes may be fabricated from the top of the chip, with one electrode being deposited on the top surface and the other in a trench that extends to below the active region. A convenient shape for the trench is annular, i.e. circular. Moreover, it is convenient to arrange an annular trench to be at least approximately concentric with the grating rings. However, in principle, the trench could be any shape, e.g. square or polygonal, and also need not be centred on the centre of the grating rings.

Instead of fabricating both electrodes from the top of the chip, one electrode may be deposited on the top surface, i.e. on the top surface of the upper cladding, and the other on the bottom surface of the chip, i.e. on the underside of the substrate.

Embodiments are possible not only with the laser beam being coupled out through the chip surface, i.e. vertically upwards through the upper cladding layer (surface emission), but also with the laser beam being coupled out vertically downwards through the lower cladding layer and the substrate (substrate emission). Substrate emission cascade lasers have several potential advantages over surface emission casced lasers, namely:
- With a surface emission design, the top metallization layer used for electrical contacting is opaque at the emission wavelength, so that apertures in the metallization are needed to allow the laser emission. In a substrate emission design, no such apertures in the top metallization are needed, which allows for simpler fabrication, more efficient electrical pumping of the gain medium and better heat extraction from the top electrode.
- Substrate emission allows for epi-down mounting, i.e. the chip can be bonded by its top-surface onto the submount that carries the chip for packaging, thus allowing for better heat extraction from the submount.
- Unlike the top surface, the chip's bottom surface, i.e. the underside of the substrate, is relatively unencumbered with features and so there is scope to incorporate extra features to provide additional functionalities. For example, optical structures may be incorporated on the bottom surface. An anti-reflection coating may be provided for reduced output losses and reduced parasitic back-reflections. Optical elements for beam shaping may be provided, such as diffractive optical elements, microlenses, prisms. The extra features may be realized by etching the bottom surface, by coating, by bonding or by overmolding, for example.
- Windowless-packaging: with substrate emission, the underside of the substrate acts as a window and can host additional optical elements. This can allow for cheaper and smaller-footprint packaging concepts, e.g. overmolding and chip-scale packages (CSP).

For surface emission, a top electrode may have an aperture to allow passage of the laser beam out of the laser without having to pass through the top electrode, e.g. an aperture that is annular and arranged co-concentrically with the grating rings. Alternatively, a transparent 'blanket' electrode may be provided, e.g. a thin degeneratively doped semiconductor layer.

The higher order grating couples out a component of the radial mode to form an output beam that propagates either in the vertical direction or with a component of its trajectory in the vertical direction. References in this document to a vertical emission cascade laser are therefore not limited to precisely vertical emission but also include emission of an output beam from the surface or substrate that propagates at an angle to the growth direction. In particular, when the higher order grating is a circular second order grating (including when provided in combination with a first order grating), the circular symmetry will ensure that all non-vertical components in the outcoupling interfere destructively, so that the output beam direction is vertical. On the other hand, with some higher order gratings, even when its rings are circular, the output beam may be at an angle away from vertical. An example is a circular third order grating.

When the higher order grating is second order, laser radiation will couple out of the active region bidirectionally, i.e. both upwards and downwards. In the case of a substrate emission design, the laser radiation that is coupled out upwards can be redirected downwards by reflection from the top electrode. The thickness of the upper cladding is then preferably specified such that, when the upwards outcoupled component that has been reflected back from the top electrode combines with the component that was outcoupled downwards, these two components interfere constructively. To deal with the same situation in a surface emission design, a DBR mirror could be fabricated below the active region. Also, in analogy to the substrate emission case, the DBR mirror should be located at an appropriate distance away from the active region to ensure constructive interference of the reflected component with the directly upwards outcoupled component when they combine.

When the higher order grating is third order, unidirectional emission may be possible, i.e. it may be possible to outcouple the laser radiation solely in the intended emission direction, i.e. upwards for surface emission and downwards for substrate emission.

It is noted that the lower cladding layer can be an integral part of the substrate, in which case a structurally distinct lower cladding layer is not present. This may be the case with a doped substrate.

The higher order grating may be configured to force the in-plane waveguide to support only a single radial mode, thereby to provide single mode laser action. Single mode operation will be the normal situation. However, the grating design might allow competition between lasing of multiple modes, especially at higher laser drive currents.

The higher order grating, and optional first order grating, can be formed by a refractive index contrast in a horizontal plane between portions of the upper or lower cladding layer where it is formed and an adjacent: metal layer; degenerately doped semiconductor layer; air; dielectric material (e.g. one used for encapsulation, such as a resin); and further layer of semiconductor material. In the case of a further layer of semiconductor material, that layer may be arranged at an interface of the upper cladding layer, i.e. by structure at the top of the upper cladding layer or at the bottom of the upper cladding layer, or by the further layer of semiconductor material being embedded within the upper cladding layer and having suitable in-plane structure. In embodiments with both a first order grating and a higher order grating, these could lie in different, vertically offset, horizontal planes, e.g. one could be formed by a refractive index contrast between two semiconductor materials at that bottom of the upper cladding layer, and the other could be formed by a refractive index contrast between the semiconductor material at the top of the upper cladding layer and a metal layer, a degenerately doped semiconductor layer, air or a dielectric material.

Embodiments in which the grating(s) are formed by structuring the top surface of the upper cladding layer in combination with air, metal or dielectric, have the advantage that the entire semiconductor growth of the layer stack can be completed before any lithographic steps need to be performed, thereby simplifying the fabrication process and also avoiding defect problems that may be caused by re-growth. In other words, etch and re-growth of semiconductor material is avoided. The only etching steps that are needed are from the top surface, namely the etch of the upper cladding layer to form the grating structure; and the etch of the trench. Since both etches are from the top surface, they take place after growth has been completed, i.e. after all semiconductor layers have been deposited.

It may be beneficial when the semiconductor layers are collectively configured so that the in-plane waveguide has a lower loss and/or higher gain central region and a higher loss and/or lower gain peripheral region in order to suppress propagation of waveguiding modes in the peripheral region of the in-plane waveguide and to promote propagation of waveguiding modes in the central region of the in-plane waveguide.

An in-plane variation of gain can be produced by restricting carrier injection to the central region, e.g. by suitable choice of the placement and extent of the electrodes. An in-plane variation of loss can be produced by providing higher loss material in the peripheral region, e.g. by depositing an absorber material around the semiconductor layer stack or by degrading the quality of one or more of the as *grown* semiconductor layers in the peripheral region, e.g. by ion bombardment, thereby to increase intrinsic losses in the as *grown* semiconductor layers. A non-circular shape of the periphery of the disk (e.g. a non-annular trench) can also be used to prevent formation of undesired peripheral optical modes and prevent constructively interfering reflections that could perturb the desired optical mode. A non-vertical etch of the periphery of the disk (i.e. the trench) may also be helpful for inhibiting constructively interfering reflections that could perturb the desired optical mode.

A wafer may be diced to provide individual lasers. Alternatively, the vertically emitting design lends itself to making one- or two-dimensional arrays of lasers. A laser array may therefore be provided that comprises a plurality of cascade lasers as described above that are formed monolithically as a single chip. This may be useful for combining multiple lasers in order to increase power output or power output density. This may also be useful for providing a laser array, where each laser has a different emission wavelength and is optionally individually drivable so that any laser in the array can be selected. The close packing of lasers with different emission wavelengths may also be useful for active infrared imaging or lidar (Light Detection and Ranging) applications.

### BRIEF DESCRIPTION OF THE DRAWINGS

This invention will now be further described, by way of example only, with reference to the accompanying drawings.
Figure 1A is a schematic cross-section of a QCL according to an embodiment of the invention using a second order CCG for outcoupling the laser emission through the substrate and for radial mode selection.
Figure 1B is a schematic plan view showing the arrangement of the second order CCG of Figure 1A.
Figure 2A is a schematic cross-section of a QCL according to an embodiment of the invention using a second order CCG for outcoupling the laser emission through the substrate in combination with a first order CCG for reinforcing radial mode selection.
Figure 2B is a schematic plan view showing the arrangement of the first and second order CCGs of Figure 2A.
Figure 3A is a schematic cross-section of a QCL according to an embodiment of the invention which has a radial gain section between first and second order grating portions.
Figure 3B is a schematic plan view of the QCL of Figure 3A.
Figure 3C is a schematic plan view of a variant of the embodiment of Figure 3A in which a second order CCG is subdivided into radially spaced subelements, each separated by a radial gain section.
Figures 4 to 12 are respective schematic cross-sections of QCLs according to further substrate emission embodiments of the invention.
Figure 13A is a schematic cross-section of a surface emission QCL according to an embodiment of the invention using a second order CCG for outcoupling the laser emission through the surface of the chip and for radial mode selection (to be compared with the substrate emission embodiment of Figures 1A and 1B).
Figure 13B is a schematic plan view showing the arrangement of the second order CCG of Figure 13A in which shading is used to show the annular metallized part of the surface and non-shaded areas show a central circular aperture in the metallization to provide for surface emission.
Figure 13C is a schematic plan view of a variant of the surface emission embodiment of Figure 13A using a second order CCG for outcoupling the laser emission through the substrate in combination with a first order CCG for reinforcing the radial mode selection (to be compared with the substrate emission embodiment of Figures 2A and 2B).
Figure 13D is a schematic plan view of a further variant of the surface emission embodiment of Figure 13A using a second order CCG for outcoupling the laser emission through the substrate in combination with a first order CCG for reinforcing the radial mode selection as well as a radial gain section between the first and second order CCGs (to be compared with the substrate emission embodiment of Figures 3A and 3B).
Figure 14 is a schematic cross-section of a surface emission QCL according to an embodiment of the invention using a second order CCG for outcoupling the laser emission through the surface of the chip and for radial mode selection (to be compared with the substrate emission embodiment of Figure 5).
Figure 15 is a schematic cross-section of an ICL according to an embodiment of the invention using a second order CCG for outcoupling the laser emission through the substrate and for radial mode selection (to be compared with the QCL embodiment of Figure 1A).
Figure 16A is a schematic perspective view of a chip with a single laser according to embodiments of the invention.
Figure 16B is a schematic perspective view of a chip with a laser array of multiple lasers according to embodiments of the invention.

### DETAILED DESCRIPTION

In the following detailed description, we use the example of the higher order grating being a second order grating. It will be appreciated that in the following embodiments the higher order grating may be replaced with third or still higher order gratings.

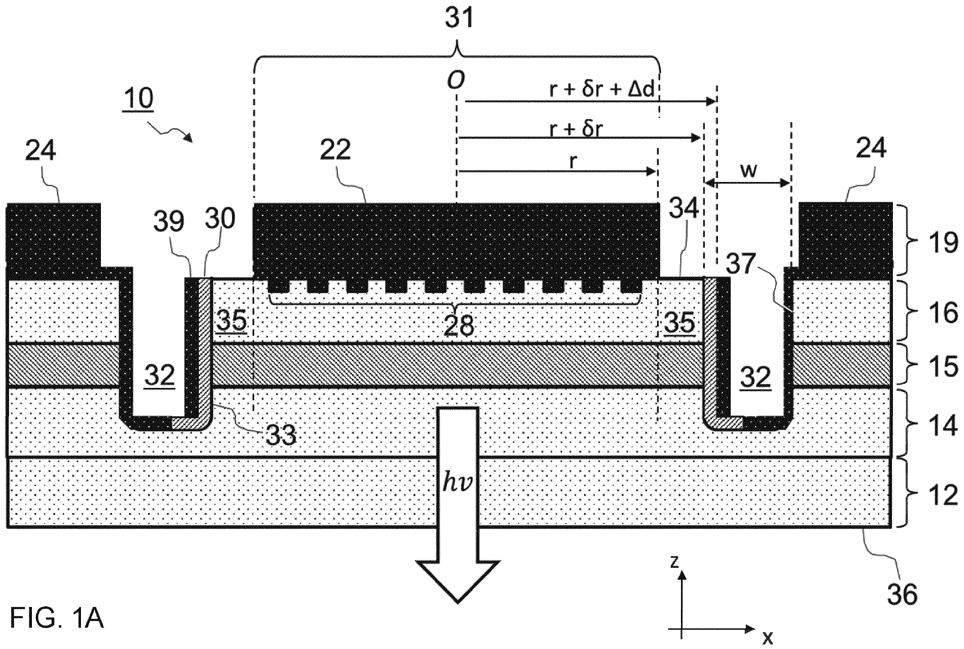

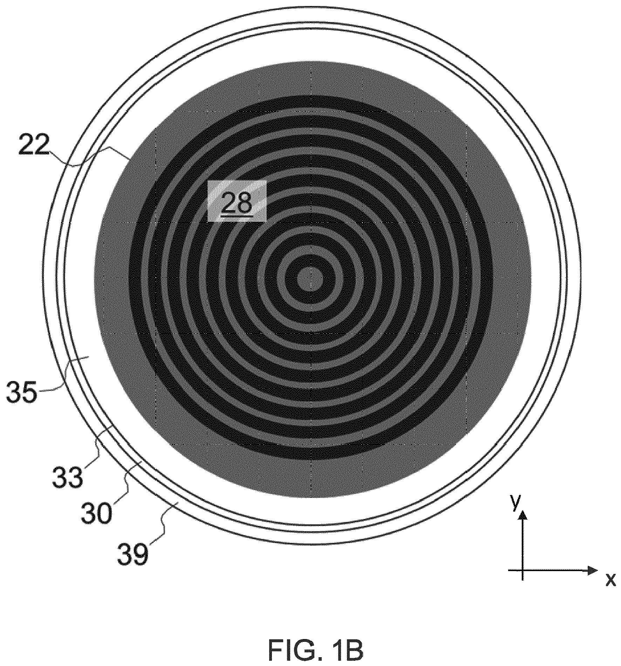

Figure 1A is a schematic cross-section of a QCL 10 according to an embodiment of the invention using a second order concentric circular grating (CCG) 28 centered around an origin point (in 2D) or axis (in 3D) which is labelled 'O' for outcoupling the laser emission through the substrate and for radial mode selection. Figure 1B is a schematic plan view of a central portion of the QCL 10 of Figure 1A showing the grating structure and related elements.

The semiconductor heterostructure is now described from the substrate upwards, i.e. in growth sequence of the layers. In a Cartesian coordinate system, the growth direction is the z-direction and the plane of the layers is an xy-plane. A doped substrate 12 is provided, e.g. from doped InP. A lower cladding layer 14, which may also be considered as a buffer layer, is deposited on the substrate 12, e.g. of doped InP. The layers for the active region 15 are then deposited including a sequence of layers formed by alternating deposition of different bandgap materials to form a superlattice structure, e.g. two materials selected from the materials system InGaAIAsP to be lattice matched to InP - most commonly InGaAs/AlInAs. Since the active region layer design is standard, its individual layers are not shown to avoid overcomplicating the drawing. An upper cladding layer 16, e.g. of InP, then follows to complete the semiconductor heterostructure, which thus terminates at a top surface 34. The bottom of the semiconductor heterostructure is formed by the bottom surface 36 of the substrate. An in-plane waveguiding region is thus formed by refractive index contrast in the vertical direction between lower refractive index, lower and upper cladding layers 14 and 16, and a higher refractive index, active region layers 15.

After growth of the semiconductor heterostructure, the chip is subjected to lithographic processing to form the CCG 28 and the necessary contacts for biasing across the active region to provide carrier injection. A circular area on the top surface 34 is structured by etching concentric circles into a small depth portion of the upper cladding layer 16 to form concentric rings. This may be done using suitable lithographic process steps. In vertical section through a diameter of the concentric rings, the structuring has the form of crenellations as illustrated. An annular trench 32 of width 'w' is etched into the top surface 34 through the upper cladding layer 16 and active region 15 and partway through the lower cladding layer 14. The annular trench 32 encloses the CCG 28. The trench 32 therefore forms an outwardly facing side surface 33 in the form of a cylinder surface of radius 'r + δr' about a cylindrical axis '*O*', an inwardly facing side surface 37 in the form of a cylinder surface of radius 'r + δr + w' and a trench base. A dielectric material layer 30 of thickness Δd is formed on the cylindrical surface 37. A metal mirror layer 39 is then formed on the dielectric layer 30. The mirror layer 39, dielectric layer 30 and disk-shaped side surface 33 are shaped and dimensioned to form a cavity for the in-plane waveguide. The dielectric layer thickness Δd is preferably close to an odd integer multiple of one quarter of the lasing wavelength (in the dielectric material), i.e. *k*·λ/4, where *k* = 1, 3, 5, 7 etc., in order to minimize absorption due to Ohmic losses at the dielectric-metal or dielectric-semiconductor boundary. Owing to the diameter of the cavity being relatively large compared with the lasing wavelength, the cavity will support multiple radial modes within the gain bandwidth of the active region layers.

The second order CCG 28 not only couples out a portion of the laser light by diffraction through the lower cladding layer 14 and substrate 12 but also reinforces amplification of one of the radial modes supported by the cavity, so that only one of the radial modes will attain the lasing threshold during operation. Emission is in the downward direction through the substrate 12 as indicated schematically by the arrow labelled *hv.* The CCG 28 thus performs a selection among the radial modes that lie within the gain bandwidth so that the cascade laser operates in single mode at a desired lasing wavelength. The pitch of the grating is therefore chosen at the design stage to coincide with only one of the multiple radial modes that lie within the gain bandwidth as supported by the shape and dimensions of the cavity. In a typical example structure, the total number of supported radial modes that lie within the gain bandwidth might be 5 to 20, where the number increases approximately linearly with increasing radius of the disk, e.g. 5 modes for a 50 µm disk radius and 20 modes for a 200 µm disk radius.

Metallization is performed not only to provide the two biasing contacts, but also to fill the concentric circular indentations (crenellations in section) and thereby create a radial modulation of refractive index in the plane of the concentric circular indentations (crenellations in section), as required for the intended grating to refract. A layer of metal 19 is deposited on the upper surface 34. This metal forms not only a circular top contact electrode 22 of radius 'r' over the portion of the top surface 34 situated radially inside the annular trench 32, but also metal for a lateral contact 24. Through suitable lithography steps, e.g. lift-off, metal can be deposited to cover the outer sidewall 37 of the annular trench 32 and form a contiguous element with the part of the metal layer 19 that is located radially outside the annular trench 32, thereby to form a lateral contact 24 for applying a voltage to the active region layers from below that is electrically separate from the top contact 22. Similarly, metal can be deposited onto the inner sidewall 33 of the annular trench 32, after deposit of the dielectric layer 30 and optional adhesion layer (not shown), to form the mirror layer 39.

It can be seen in Figure 1A that the top contact 22 does not radially extend to the outwardly facing side surface 33 of the layer stack 14, 15, 16 that forms an in-plane waveguide region. Rather, there is a peripheral region 35 not covered by the top contact 22 which surrounds a central region 31 covered by the top contact 22. The in-plane waveguide is thus subdivided into a higher gain central region 31 and a lower gain peripheral region 35. This has the effect of suppressing propagation of non-radial modes, such as whispering gallery modes, in the peripheral region 35. It will be understood that this gain difference is a result of waveguiding in the peripheral region 35 being passive, since there is no current injection from the top contact 22 (making the simplifying assumption of purely vertical carrier movement) or more accurately taking account of lateral current spreading much reduced current injection compared with to the central region 31 lying directly below the top contact 22.

It will be understood that although the cladding layers 14 and 16 are illustrated and described as single layers, they may be formed by multiple layers. Moreover, the substrate 12 may serve as the lower cladding layer 14, in which case a separate lower cladding layer would be omitted.

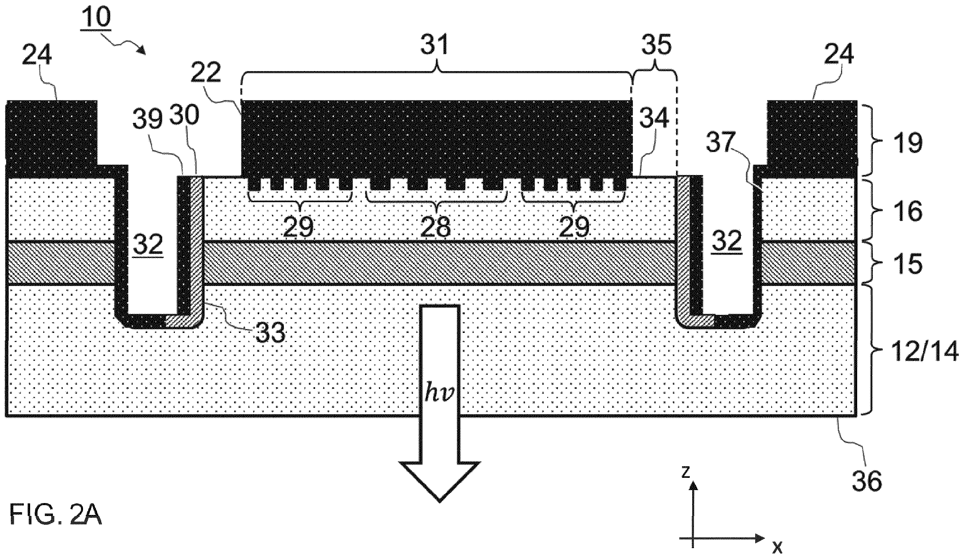

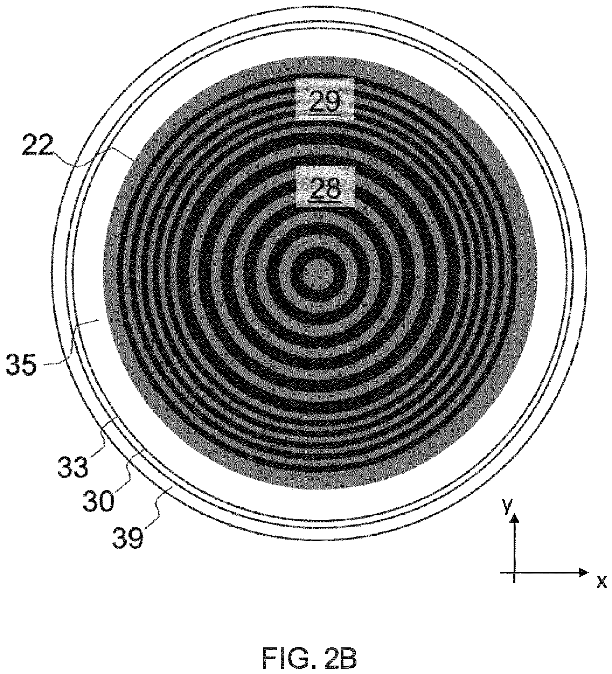

Figure 2A is a schematic cross-section of a QCL 10 according to an embodiment of the invention with a grating structure comprising a second order CCG 28, which principally has the role of outcoupling the laser emission through the substrate, in combination with a first order CCG 29, whose role is to reinforce the radial mode selection of the grating structure in order to pick out one (or more) of the radial modes defined by the cavity, so that only the selected mode attains the lasing threshold in use. Figure 2B is a schematic plan view showing the arrangement of the first and second order CCGs 29, 28 of Figure 2A. A disk-shaped side surface 33 formed by the inner trench wall laterally encloses the in-plane waveguide and is coated with a dielectric layer 30 followed by a metal or semiconductor mirror layer 39, thereby forming a cavity for the in-plane waveguide which supports multiple radial modes. The embodiment of Figures 2A and 2B differs from that of Figures 1A and 1B only in two respects. First, as foreshadowed above, the substrate 12 also serves as the lower cladding layer 14, so a separate lower cladding layer 14 is not present. Second, the grating design is different. Namely, an additional first order grating 29 is arranged radially outside the second order grating 28. The first order grating 29 has the function of causing in-plane reflection over a narrow wavelength range selected to coincide with both the gain bandwidth of the gain medium and one or more of the multiple radial modes capable of being sustained within the cavity that lie within the gain bandwidth.

In variants of this embodiment, the first order grating 29 could be arranged sandwiched, i.e. interposed, between a radially inner and a radially outer part of the second order grating 28. Another variant would be to have the first order grating 29 arranged radially inside the second order grating 29. Indeed, it can be advantageous to place the first order grating 29 close to the center to control the vertical outcoupling and thereby the cavity losses, and to place the second order grating 28 radially outside the first order grating 29, to provide a lower beam divergence of the output beam. (This statement also applies to embodiments which use a higher than second order grating.)

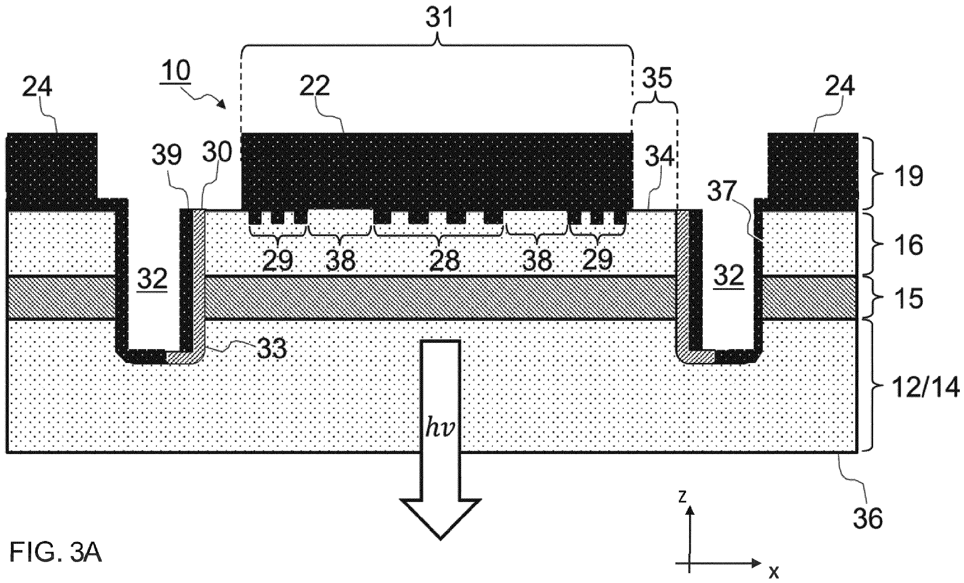

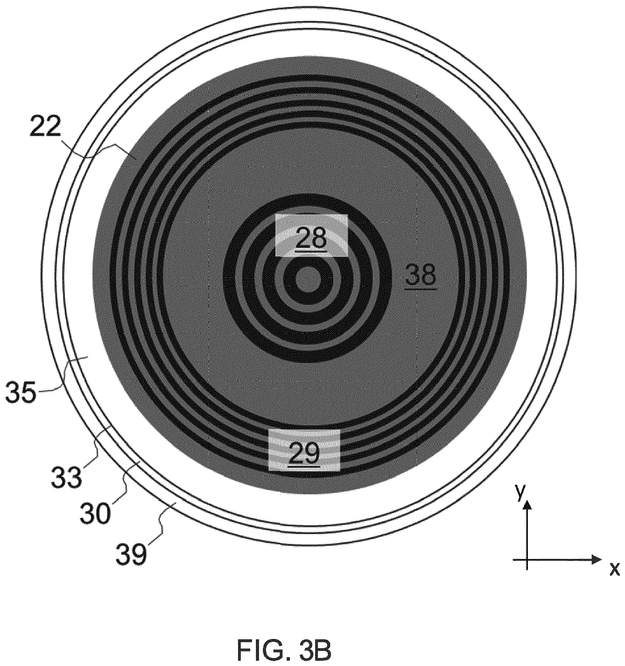

Figure 3A is a schematic cross-section of a QCL 10 according to an embodiment of the invention in which the first and second order CCG portions 29, 28 are separated by a radial gain section 38. Figure 3B is a schematic plan view of the QCL 10 of Figure 3A showing this arrangement. Namely a radial gap exists between the radially outer first order grating portion 29 and the radially inner second order grating portion 28. The gap acts as a gain section 38 between the second and first order grating portions 28, 29. It is also noted that a separate lower cladding layer 14 is provided in the same way as in the embodiment of Figures 1A and 1B. In variants of this embodiment, the gain section 38 could be radially inside both the first and second order gratings 29, 28. In other variants, the sequence of these features from the centre outwards could be gain section 38, first order grating 29, second order grating 28.

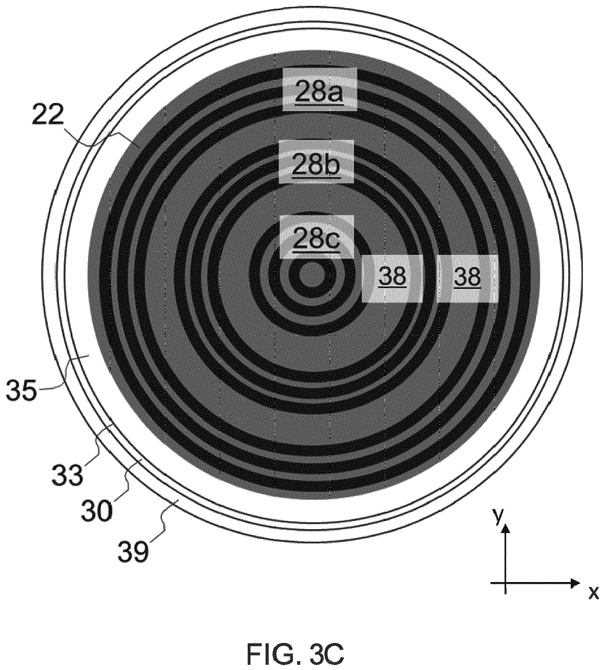

Figure 3C is a schematic plan view of a variant of the embodiment of Figure 3A in which there is only a second order CCG 28 present (i.e. no first order CCG) and the second order CCG 28 is subdivided into radially spaced subelements 28a, 28b, 28c, each separated by a radial gain section 38. In a further variant, any one or two of the subelements 28a/28b/28c could be substituted with a first order grating 29.

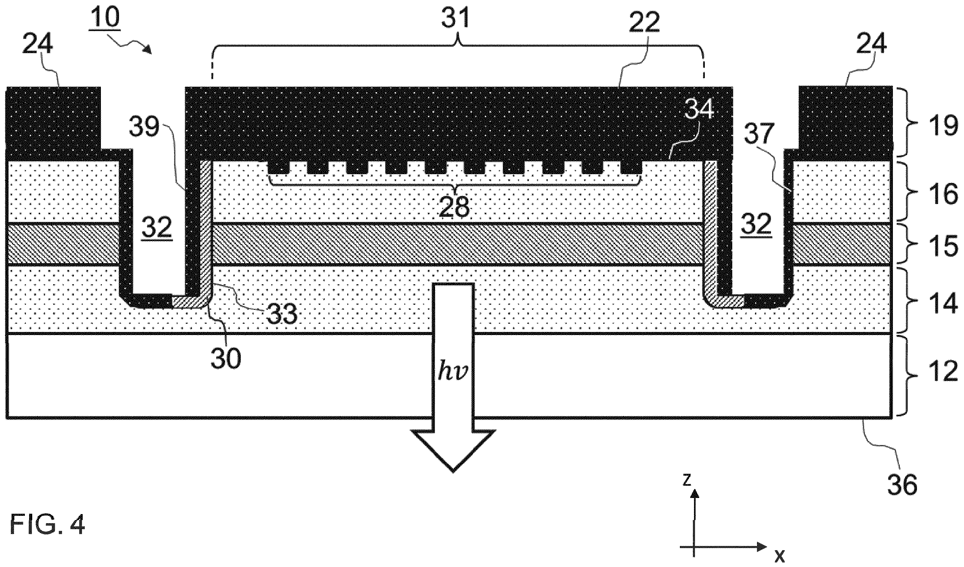

Figures 4 to 12 are respective schematic cross-sections of QCLs 10 according to further embodiments of the invention, all of which couple out the laser emission through the substrate. These embodiments are described by way of highlighting differences from preceding embodiments. It is also noted that all of Figures 4 to 12 show a grating design the same as in the embodiment of Figures 1A and 1B, but can each be varied to incorporate the grating design of Figures 2A and 2B, or Figures 3A and 3B, or Figure 3C.

Figure 4 shows an embodiment that has a nominally undoped (or low doped) substrate 12 instead of the doped substrates of the previous embodiments. Nominally undoped or low doped may, for example, mean a doping concentration of less than 1e16 cm-3. For a substrate emission design as shown, having a substrate with no or little intentional doping will minimize the absorption of the laser light as it passes through from the active region layers after refraction from the grating. The lower cladding layer 14 formed on the substrate 12 is doped, as is the upper cladding layer 16. In Figure 4, the option of forming the top contact electrode 22 up to the trench 32, i.e. up to vertical alignment with the trench side surface 33, is also shown, so that in this embodiment carrier injection takes place substantially equally across the full horizontal extent of the in-plane waveguide. Moreover, in this embodiment the option is shown of having the metal of the mirror layer 39 contiguous with the metal of the top contact 22.

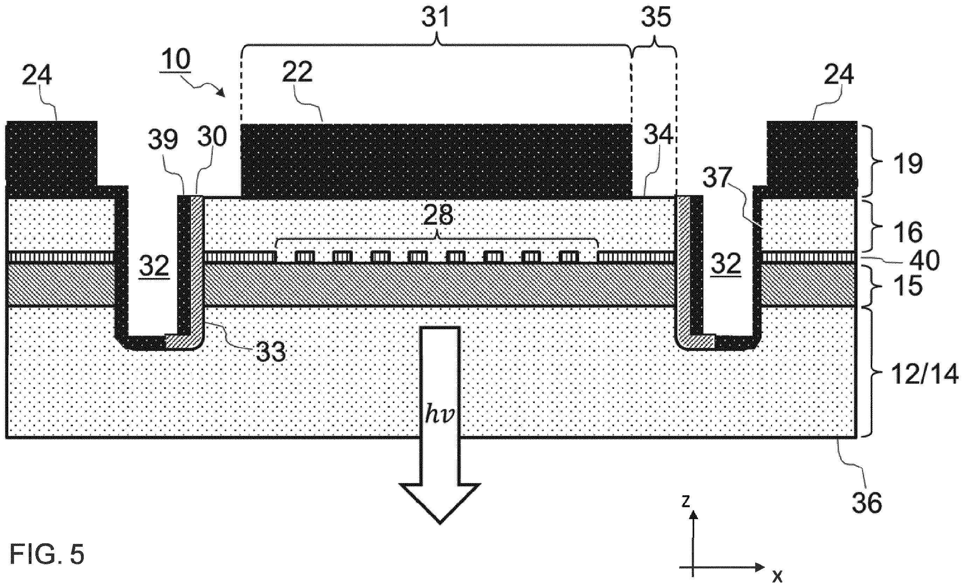

Figure 5 shows an embodiment with a different way of fabricating the grating structure. The second order CCG 28 is shown, but the same fabrication approach is also applicable if a first order CCG would be included. Instead of forming the second order grating 28 by etching into the top surface 34 and metal infilling, the second order grating 28 is formed as a layer 40 buried within the semiconductor heterostructure. After completion of the growth of the active region layers, a layer of semiconductor material is deposited. The layer is then selectively removed by patterning and etching in a circular central area to leave the layer 40 as illustrated. The structured surface is then overgrown by the upper cladding layer 16 to form the second order grating 28. What is important for the formation of the second order grating 28 is a refractive index difference between the semiconductor material of the grating layer 40 and the semiconductor material of the upper cladding layer 16, so the semiconductor material of the layer 40 could have lower or higher refractive index than that of the upper cladding layer 16. It is also noted that the doped substrate 12 also serves as the lower cladding layer 14 in this embodiment. In variants of this embodiment, a first order grating 30 may be included co-planar with the second order grating 28. The first order grating 30 may be arranged radially outside or inside the second order grating 28, or in a sandwich arrangement as discussed further above. Another option would be to form a first order grating 30 in a separate plane by structuring the upper suface of the upper cladding layer 16 in combination with metal infill from the top electrode 22 (i.e. as shown in Figure 2A). This shows that embodiments are possible in which the first order grating and second order grating are formed in different planes vertically offset from one another.

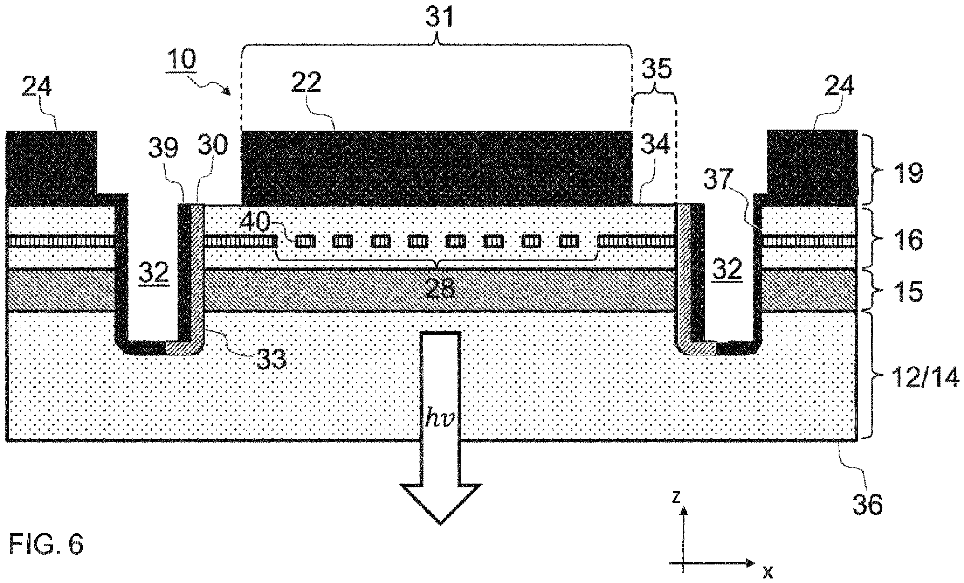

Figure 6 shows an embodiment which differs from that of Figure 5 only in that the grating layer 40 is formed part way up the upper cladding layer 16. During the crystal growth, after completion of the active region layers, a portion of the upper cladding layer 16 is deposited, then the grating layer 40. After structuring the grating layer 40, growth of the upper cladding layer 16 is continued.

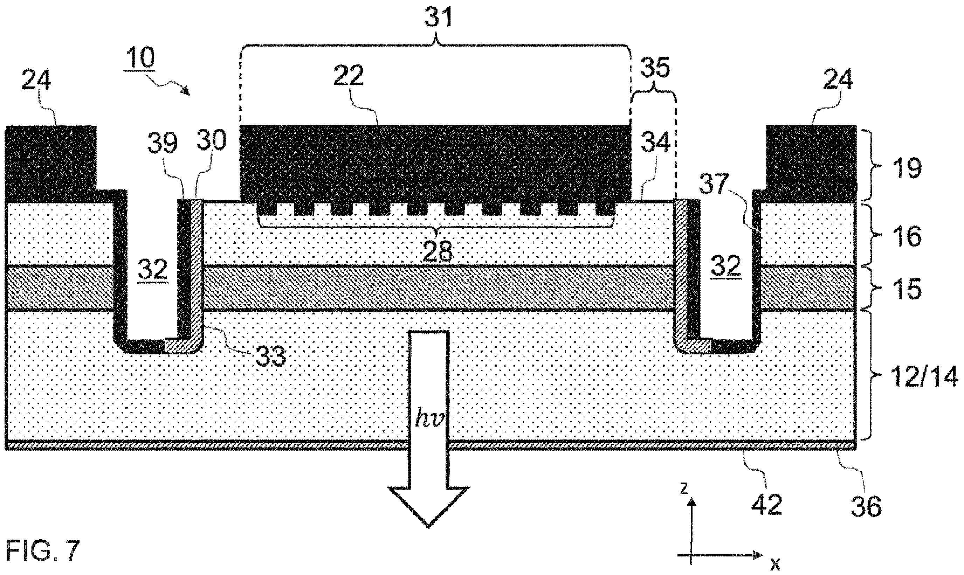

Figure 7 shows an embodiment that is the same as that of Figures 1A and 1B, except that an anti-reflection coating 42 is deposited on the bottom surface 36 of the substrate to reduce output losses and reduce back reflections which may cause instabilities in the laser operation.

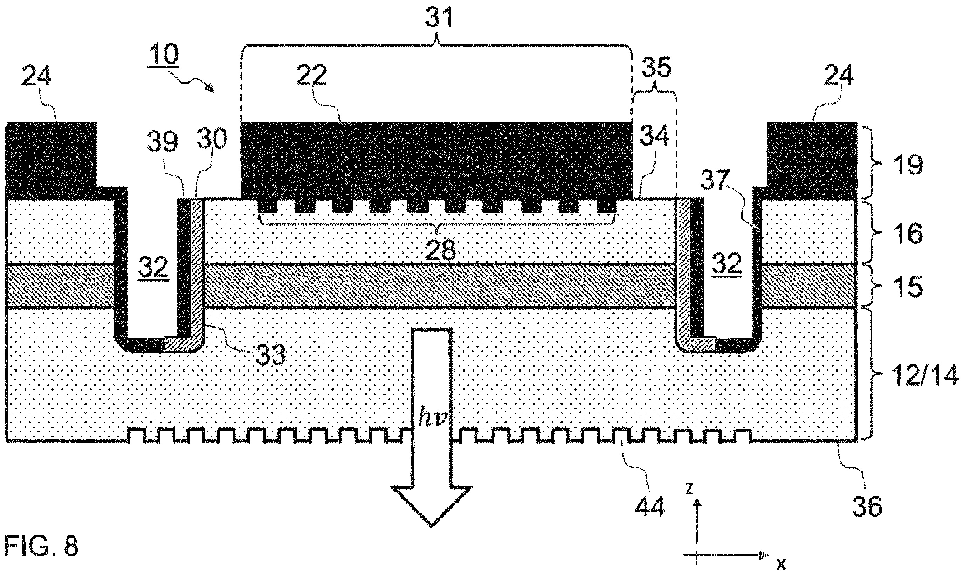

Figure 8 shows an embodiment that is the same as that of Figures 1A and 1B, except that structure is etched into the bottom surface 36 of the substrate to form an integrated optical element 44, for example a diffractive optical element (DOE) or some other component for beam shaping or modifying the laser emission.

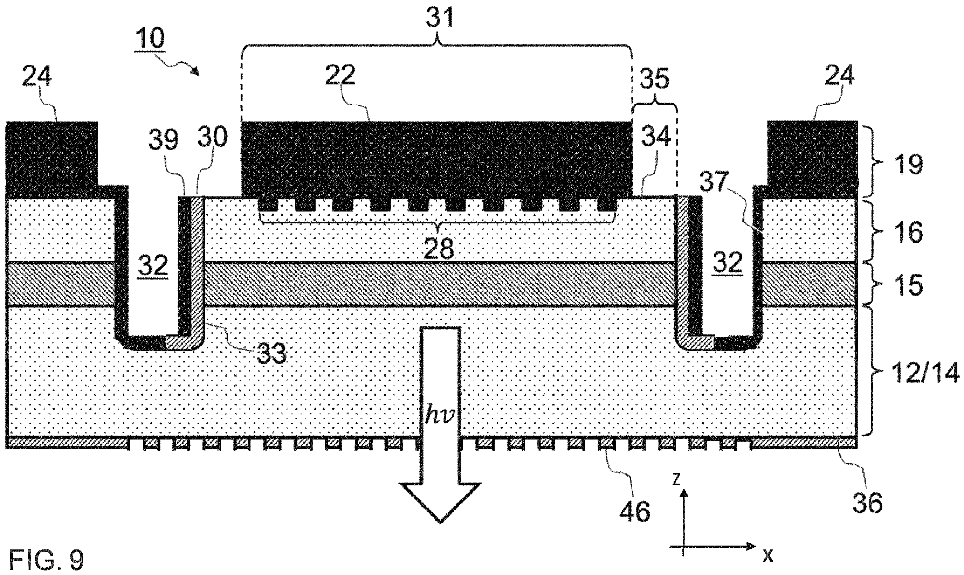

Figure 9 shows an embodiment that is the same as that of Figures 1A and 1B, except that an additional layer or layers are formed on the bottom surface 36 of the substrate to form an integrated optical element 46. The extra layer(s) may be formed by deposition, bonding, transfer molding or some other method.

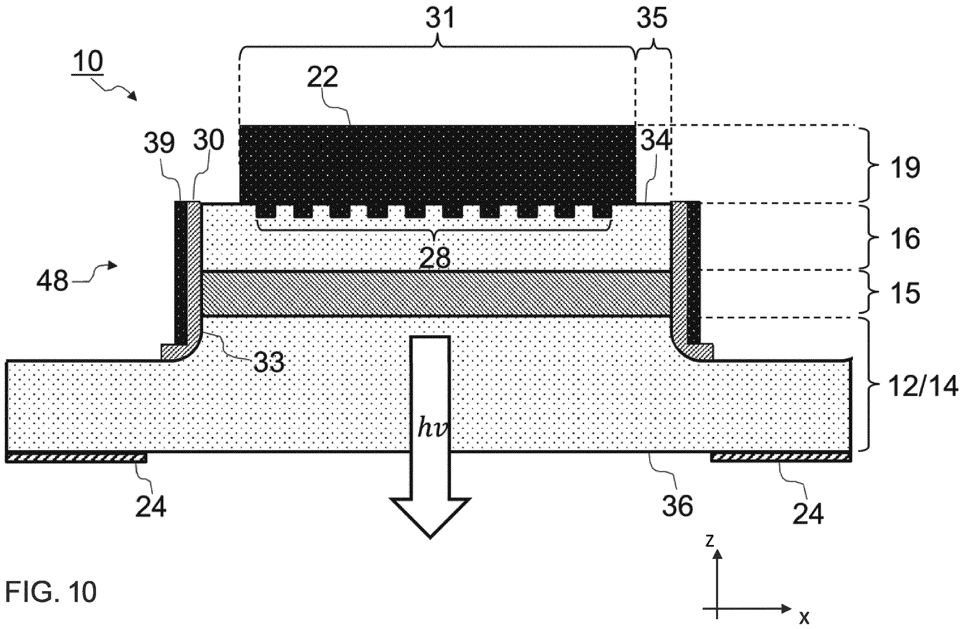

Figure 10 shows an embodiment that has the same layer sequence as that of Figures 2A and 2B. The provision of a doped substrate 12 allows a bottom contact 24 to be deposited on the bottom surface 36 of the substrate 12, as an alternative to the lateral contact of previous embodiments, thereby obviating the need for the annular trench design of the previous embodiments. A doped substrate may have a doping concentration of greater than 1e17 cm-3, for example. The chip is etched into a mesa form 48 to guide the carrier injection into the active region, with the mesa extending through the upper cladding layer 16, the active region 15 and part way through the substrate 12. The bottom contact 24 has an aperture to allow for downward laser emission through the substrate 12. The mesa 48 therefore forms the disk-shaped side surface 33 that laterally bounds the in-plane waveguide.

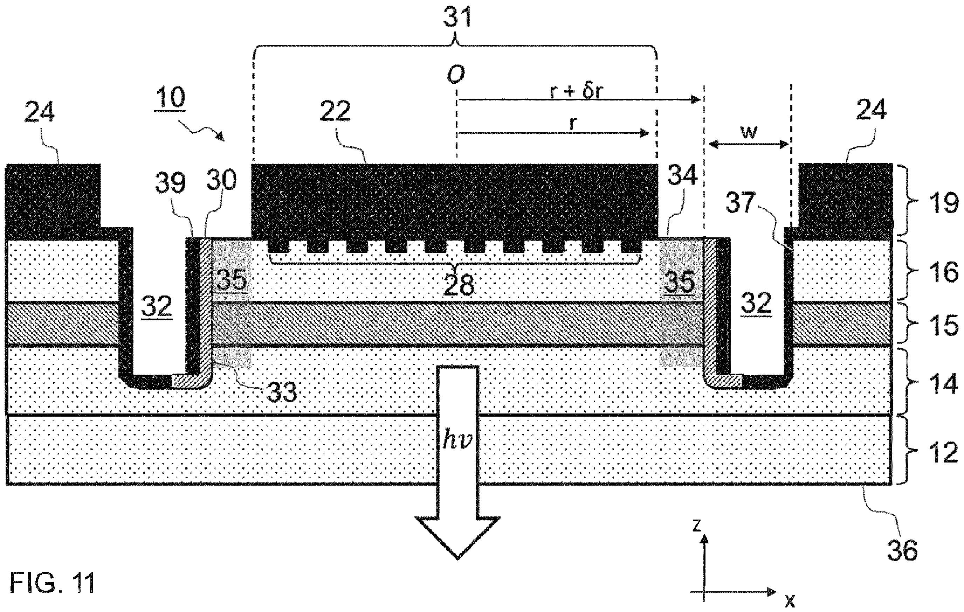

Figure 11 shows an embodiment that is the same as that of Figures 1A and 1B except that at least a portion of the peripheral region 35 lying radially between the outside of the grating structure 28 (or 28 and 30) and the waveguide stack's side surface 33 is formed of a higher absorbing, i.e. lossier, material in order to suppress non-radial waveguide modes, such as whispering gallery modes. The lossy region 35 can be made to have higher losses, i.e. to be more absorbent to photons with wavelengths that are waveguided by the waveguiding layer stack 14, 15, 16 than is the case for the as *grown* layers 14, 15 and/or 16 through post-processing. A suitable method is ion bombardment from above using the top contact 22 as a shadow mask. The lossier material extends vertically through at least a part of the depth of the waveguide stack, i.e. over at least part of the depth of layers 16, 15 and 14, as schematically illustrated with the shading that extends through layers 16 and 15 and part way into layer 14. In this embodiment, there is not only a gain difference between the central and peripheral regions 31, 35 as a result of the locality of the current injection into the gain region but also an absorption difference as a result of the lossier material that is incorporated in the peripheral region 35. The in-plane waveguide thus has a lower loss and higher gain central region 31 and a higher loss and lower gain peripheral region 35. It will be further understood that for embodiments such as that of Figure 4 it is possible to include lossy material to provide differential losses as just described, even though gain may be the same across the whole in-plane waveguide.

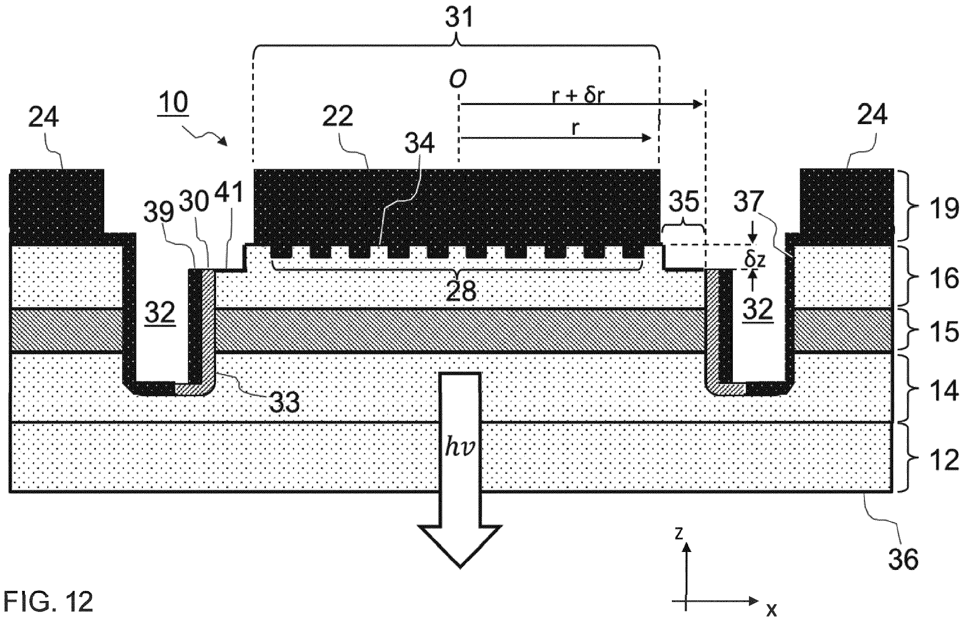

Figure 12 shows an embodiment that is the same as that of Figures 1A and 1B except that a step 41 of depth 'δz' is etched away from the top surface 34 in the peripheral region 35. The effect of this additional etch is to remove an upper part of the upper cladding layer 16 from the peripheral region 35, so that any lateral current spreading that may have otherwise occurred into that upper part can no longer take place, thereby enhancing the loss effect of the peripheral region 35.

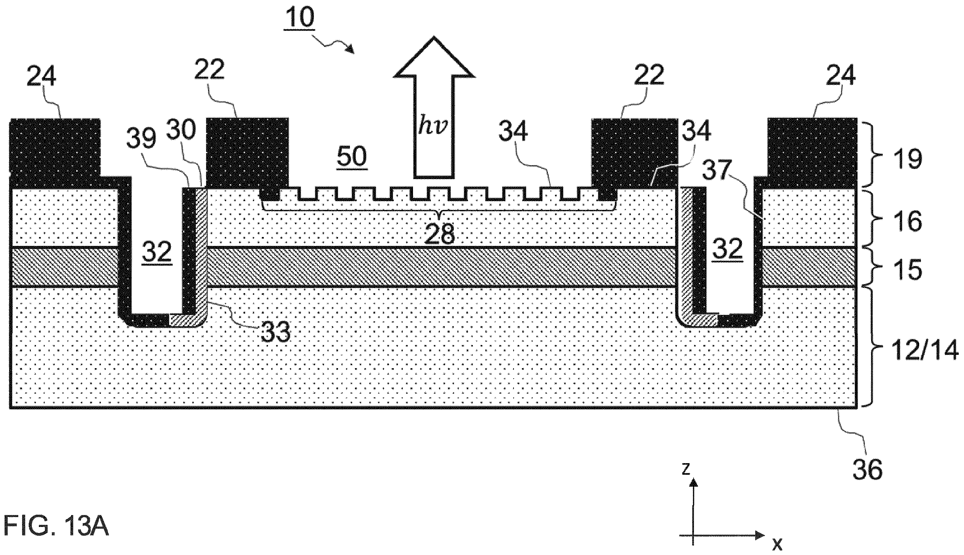

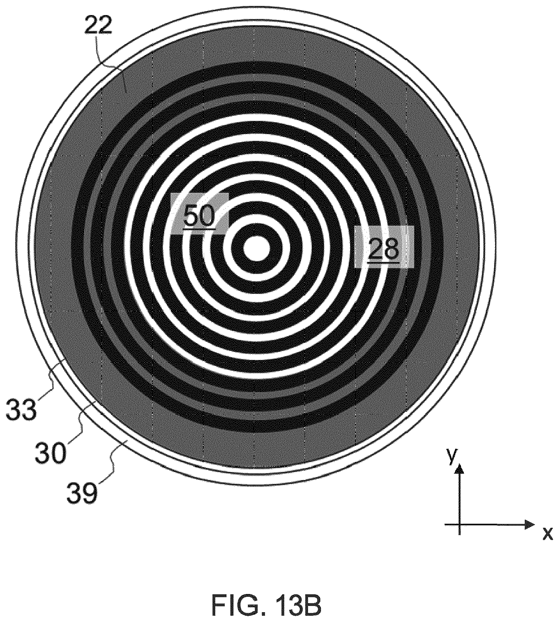

Figure 13A is a schematic cross-section of a surface emission QCL 10 according to an embodiment of the invention using a second order CCG 28 for outcoupling the laser emission through the surface of the chip and for radial mode selection. Figure 13B is a schematic plan view of Figure 13A. This embodiment is to be compared with the substrate emission embodiment of Figures 1A and 1B. The top contact 22 is annular in form, thereby creating a circular aperture 50 to allow for laser emission through the top surface 34. Figure 13B uses shading to show the annular metallized part of the surface and non-shaded areas to show the central circular aperture 50. The aperture 50 is shown extending radially over a central portion of the grating 28, a rim portion of the grating 28 being covered by the metallization of the top contact 22. In variants of this embodiment, the aperture 50 could uncover the whole grating 28.

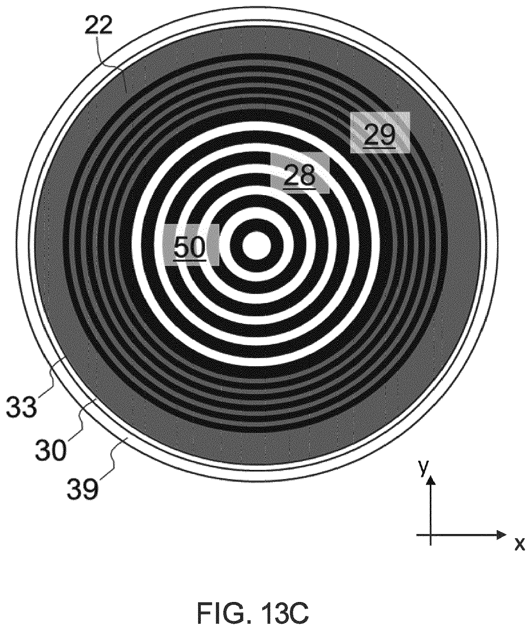

Figure 13C is a schematic plan view of a variant of the surface emission embodiment of Figure 13A using a second order CCG 28 for outcoupling the laser emission through the surface in combination with a first order CCG 29 for radial mode selection (to be compared with the substrate emission embodiment of Figures 2A and 2B). Shading is used to show the annular metallized part of the surface and non-shaded areas to show a central circular aperture in the metallization to provide for surface emission.

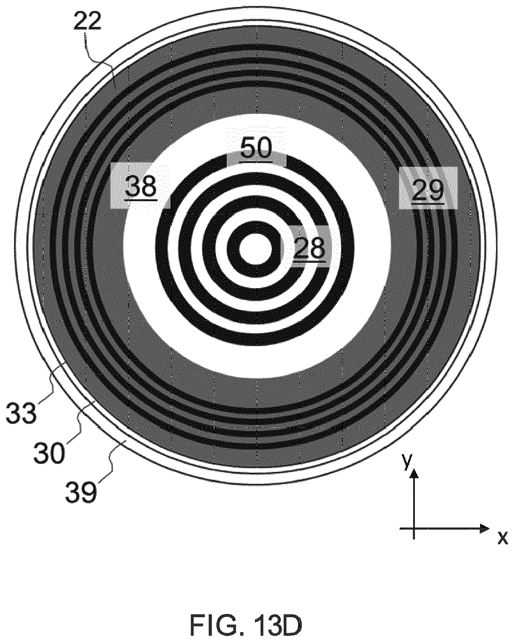

Figure 13D is a schematic plan view of a further variant of the surface emission embodiment of Figure 13A using a second order CCG 28 for outcoupling the laser emission through the surface in combination with a first order CCG 29 for radial mode selection as well as a radial gain section 38 between the first and second order CCGs (to be compared with the substrate emission embodiment of Figures 3A and 3B). Shading is used to show the annular metallized part of the surface and non-shaded areas to show a central circular aperture in the metallization to provide for surface emission.

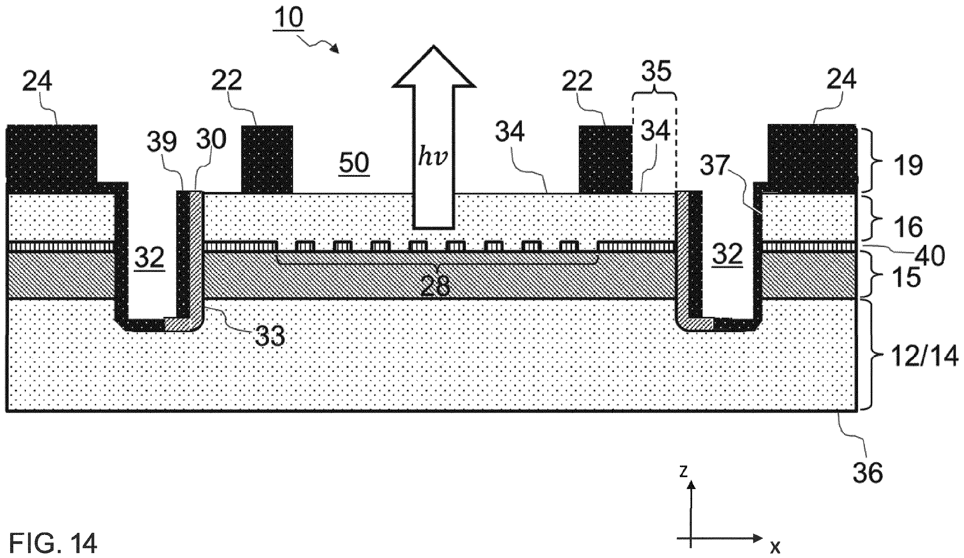

Figure 14 is a schematic cross-section of a surface emission QCL 10 according to an embodiment of the invention using a second order CCG 28 for outcoupling the laser emission through the surface of the chip and for radial mode selection. This embodiment is to be compared with the substrate emission embodiment of Figure 4. The top contact 22 is annular in form, thereby creating a circular aperture 50 to allow for laser emission through the top surface 34. In plan view, the top electrode 22 is arranged in relation to the CCG 28 similarly to as shown in Figure 12B.

It will be appreciated that the different features of the QCL embodiments of Figures 1 to 14 can be combined in many permutations to provide further QCL embodiments that mix these features.

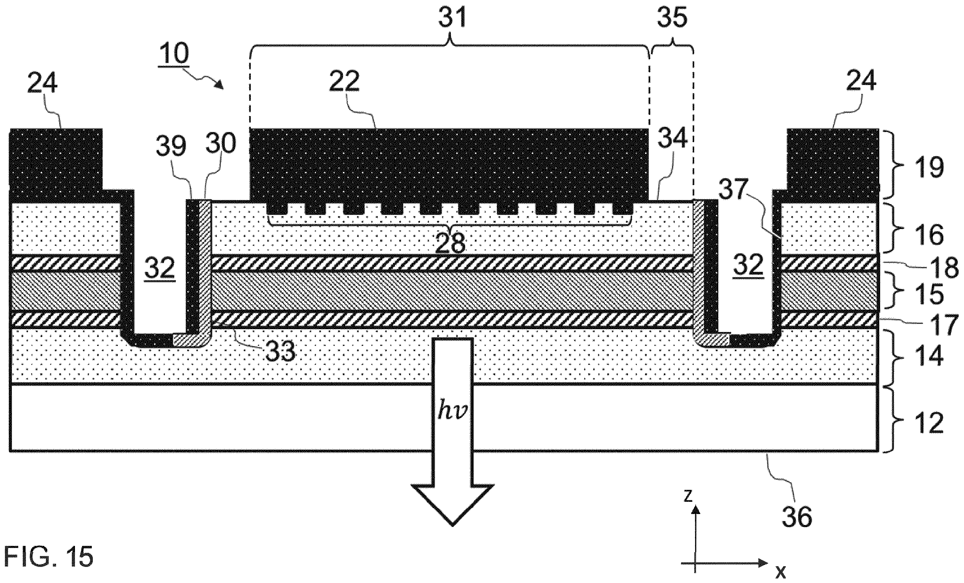

Figure 15 is a schematic cross-section of an ICL 10 according to an embodiment of the invention using a second order CCG 28 for outcoupling the laser emission through the substrate and for radial mode selection. This embodiment is to be compared with the QCL embodiment of Figure 1A. In an ICL, as compared to a QCL, the waveguiding is produced differently, since the active region 15 will not generally have a high enough refractive index relative to the cladding layers 14, 16. In order to provide in-plane waveguiding and hence sufficient overlap between the waveguiding mode(s) and the gain medium provided by the active region 15, there are provided lower and upper separate confinement layers (SCLs) 17 and 18. The SCLs 17 and 18 are of higher refractive index and provided either side of the active region 15. The substrate 12 may be GaSb, either undoped as schematically shown or n-type. The SCLs 17 and 18 may be formed n-doped GaSb. The cladding layers 14, 16 are lightly doped n-type and may be of bulk alloy AIGaAsSb that is lattice matched to GaSb, i.e. the substrate material, or InAs/AISb superlattices. The active region of an ICL are an active quantum well (QW) part, a hole injector part, and an electron injector part. The active QW part may be formed by InAs/GaInSb QWs. The hole injector part may be formed by coupled GaSb/AlSb QWs. The electron injector part may be formed of coupled InAs/AISb QWs. In an ICL, in view of the narrow bandgap materials, it may also be convenient for the top contact material 19 to be a degeneratively doped semiconductor instead of a metal, e.g. n+ doped InAs(Sb).

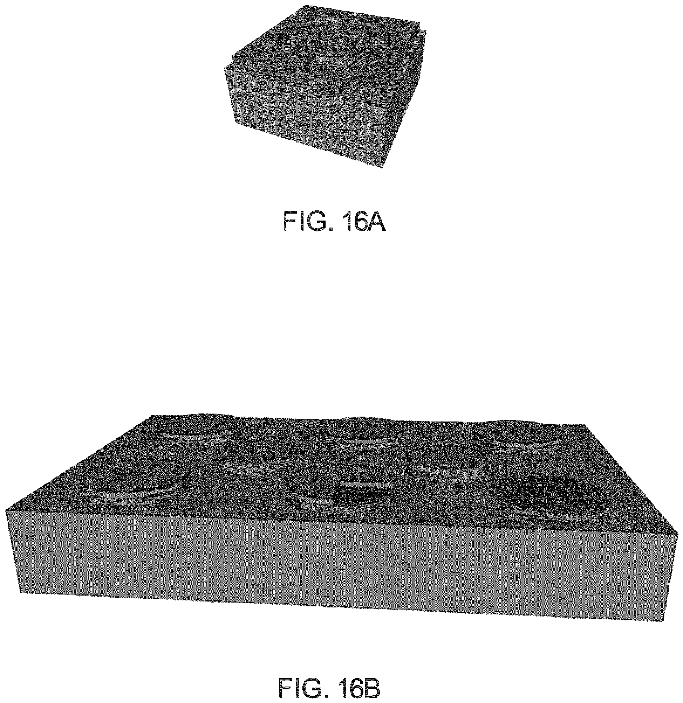

Figure 16A is a schematic perspective view of a chip with a single laser according to embodiments of the invention.

Figure 16B is a schematic perspective view of a chip with a laser array of multiple lasers according to embodiments of the invention. Partial cut-aways of two of the lasers are illustrated to show the grating structure. A 2D array of lasers are shown with an offset packing. In other embodiments, the packing may be according to a square grid, or in concentric circles. In other embodiments, the array may be a 1D array, e.g. arranged in a line or circle.

General aspects of the grating design are now discussed that are applicable to all of the above embodiments.

The periodicity Λ of a linear grating of order *m* is Λ = *m*·λ / 2·*n.* The periodicity for a first (*m*=1) order linear grating is therefore λ / 2·*n* and the periodicity for a second (*m*=2) order linear grating is λ / *n*. However, due to the circular geometry of the resonator, the optimal periodicity is not constant as for a linear grating but varies slightly in the radial direction following a Bessel distribution. The condition for the second order grating to control the vertical emission is to allow for a wavevector in the vertical direction while, for the radial mode selection, the second order grating needs to allow for a wavevector in the plane. (The same can be generalized for all higher orders, i.e. all *m* ≥ 2.)

Even though the theoretically optimum designs for achieving these conditions are quite clear, i.e. following a Bessel distribution, deviations from the theoretical ideal may be exploited to engineer other desirable properties of the laser. These deviations and their effects on performance would be explored through simulations at the design stage. In particular for the vertical extraction, the second order grating positions can be shifted, at least over a part of the grating, away from the theoretical optimum so as to provide effects such as: to provide more or less outcoupling (which may be desirable to tune according to how much gain is present), to favor emission of a certain polarization, or to attain a certain desired far field distribution of the emitted beam. Whatever deviations from the optimum are used, the second order grating must allow a component of the wavevector in the vertical direction, so that outcoupling is achieved.

There is no particular minimum or optimum number of grating rings to form an effective first order, second order or still higher order grating. The number of rings that are needed depends on factors such as the refractive index contrast in the plane of the grating and how strongly the grating needs to couple with the relevant radial mode. A typical minimum number of rings for good performance might be 10-20. A typical number of rings might be anywhere from the minimum up to perhaps 250-500.

For any of the above embodiments, the following general comments apply.

Typical emission wavelengths for QCL and ICL embodiments of the invention are 2 to 20 micrometers.

Suitable semiconductor materials systems for fabrication are GaAlAs (sometimes referred to as arsenide-based), GaAlInAsP (sometimes referred to as phosphide-based), and GaAlInAsSb (sometimes referred to as antimonide-based). Suitable electrode materials include Ge and the metals Au, Ti, Ni and Pt.

The upper and lower cladding layers are typically n-type doped. The active region layer sequence may be grown in either an *np* or *pn* sequence. Consequently, in different embodiments the biasing for current injection across the contacts, i.e. across the top and lateral contact or across the top and bottom contact, may be in either sense. Most commonly for a QCL and ICL the upper and lower claddings are both n-type and the top contact is the negative contact.

The active region for forming the QCL or ICL can follow any known design. For this reason, the precise layer sequence of the active region has not been described in detail. For QCLs, the most common designs are bound-to-bound, bound-to-continuum and continuum-to-continuum.

The grating can be formed lithographically with an etch and optionally also a fill. A semiconductor layer is etched and then the gaps in that layer are filled with a suitable semiconductor material or metal (or metallic) material to provide the necessary in-plane refractive index contrast. To define a mask for the grating, UV or deep-UV lithography may be used, or alternatively e-beam lithography. The etch may be wet or dry, *e.g.* by reactive ion etching. For embodiments that have semiconductor-semiconductor gratings, more fabrication details can be found in Kapsalidis *et* a/2018 [6]. For embodiments that have semiconductor-metal gratings, more fabrication details can be found in Wu *et al* 2017 [7].

For substrate emission embodiments, integrated optical elements can be provided on the underside of the substrate. Optical elements may be fabricated, for example, by directly etching the surface of the substrate, by etching material(s) layer(s) deposited on the substrate or even by attaching a pre-fabricated optical element to the substrate, such as be transfer molding. The optical elements can be for example lenses (including microlenses), polarizing elements, beam steering elements, wavefront shaping elements.

For substrate emission embodiments, the substrate may be partially or wholly etched away below the higher order grating to reduce absorption losses. In this configuration, the higher order grating could also be formed on the lower surface of the lower cladding which would be exposed by the substrate etch.

It will be clear to one skilled in the art that many improvements and modifications can be made to the foregoing exemplary embodiment without departing from the scope of the present disclosure.

### REFERENCE NUMERALS

- 10: cascade laser, QCL or ICL
- 12: substrate
- 14: lower cladding layer (buffer layer)
- 15: active region (multiple layers)
- 16: upper cladding layer
- 17: lower separate confinement layers (in an ICL)
- 18: upper separate confinement layers (in an ICL)
- 19: top metal structure
- 20: bottom metal structure
- 22: top contact
- 24: lateral or bottom contact
- 28: second order concentric circular grating portion
- 29: first order concentric circular grating portion
- 30: dielectric material layer
- 31: low loss / high gain central region
- 32: trench for contact formation
- 33: outwardly facing disk-shaped side surface of trench (or waveguide layer stack)
- 34: top surface of semiconductor heterostructure
- 35: higher loss and/or lower gain peripheral region
- 36: bottom surface of semiconductor heterostructure
- 37: inwardly facing side surface of trench
- 38: radially extending gain section(s) between adjacent concentric grating portions
- 39: cavity forming metal or semiconductor mirror layer
- 40: semiconductor grating material layer
- 41: etch step
- 42: anti-reflection coating
- 43: lossy material ring
- 44: integrated optics substrate surface structure
- 45: exposed lower surface of lower cladding layer
- 46: integrated optics layer
- 48: mesa
- 50: top contact aperture
- 52: chip with single laser
- 54: chip with laser array

### REFERENCES

1. M. J. Süess et al., "Single-Mode Quantum Cascade Laser Array Emitting From a Single Facet," in IEEE Photonics Technology Letters, vol. 28, no. 11, pp. 1197-1200, 1 June 2016, (doi: https://doi.org/10.1109/LPT.2016.2533443)
2. R. Szedlak, C. Schwarzer, T. Zederbauer, H. Detz, A. Andrews, W. Schrenk, and G. Strasser, "Grating-based far field modifications of ring quantum cascade lasers," Opt. Express 22, 15829-15836 (2014) (doi: https://doi.org/10.1364/OE.22.015829)
3. Mahler, L., Tredicucci, A., Beltram, F. et al. Vertically emitting microdisk lasers. Nature Photon 3, 46-49 (2009) (doi: https://doi.org/10.1038/nphoton.2008.248)
4. G. Liang, H. Liang, Y. Zhang, L. Li, A. Davies, E. Linfield, S. Yu, H. Liu, and Q. Wang, "Low divergence single-mode surface-emitting concentric-circular-grating terahertz quantum cascade lasers," Opt. Express 21, 31872-31882 (2013) (https://doi.org/10.1364/OE.21.031872)
5. US 2019/074663 A1 (Toshiba)
6. Kapsalidis, F., Shahmohammadi, M., Süess, M.J. et al. Dual-wavelength DFB quantum cascade lasers: sources for multi-species trace gas spectroscopy. Appl. Phys. B 124, 107 (2018) (https://doi.org/10.1007/s00340-018-6973-2)
7. Wu, D. H., Razeghi, M. High power, low divergent, substrate emitting quantum cascade ring laser in continuous wave operation. APL Materials 5, 035505 (2017). (https://doi.org/10.1063/1.4978810)

## Claims

1. A cascade laser (10) configured to emit laser light at a lasing wavelength, A, the cascade laser comprising:
an in-plane waveguide formed by a semiconductor layer stack comprising in sequence a lower cladding layer (14), a plurality of active region layers (15) to provide gain and an upper cladding layer (16), the in-plane waveguide being bounded laterally into a disk shape by a side surface (33);
a mirror layer (39) arranged over the disk-shaped side surface (33), the mirror layer (39) and disk-shaped side surface (33) being shaped and dimensioned to form a cavity for the in-plane waveguide which supports multiple radial modes; and
a grating structure (28; 28, 29) of concentric rings formed in one of the upper and lower cladding layers (14, 16), the grating structure including at least a higher order grating portion (28) of order *m ≥ 2* and serving both to select at least one of the multiple radial modes for lasing and to couple out the laser light through at least one of the lower and upper cladding layers (14, 16).

2. The laser of claim 1, wherein the grating structure additionally includes a first order grating portion (29) with *m* = *1*.

3. The laser of claim 1, wherein the grating structure consists solely of the higher order grating portion (28).

4. The laser of any preceding claim, wherein the mirror layer (39) provides a reflectivity of at least one of 90%, 91%, 92%, 93%, 94% and 95% at the lasing wavelength.

5. The laser of any preceding claim, further comprising a dielectric layer (30) of a dielectric material formed in between the disk-shaped side surface (33) and the mirror layer (39).

6. The laser of claim 5, wherein the dielectric layer (30) has a thickness that approximates roughly to an odd integer multiple of one quarter of the lasing wavelength within the dielectric material, namely a thickness in the range 0.1 to 0.5 · *k* · *λ*/*n_{d}* , more particularly 0.2 to 0.3 · *k* · *λ*/*n_{d}*, where *k* = 1, 3, 5, 7 .... and *n_{d}* is the refractive index of the dielectric material at the lasing wavelength.

7. The laser of claim 6, wherein the mirror layer (39) and the dielectric layer (30) cooperate to provide a reflectivity of at least one of 96%, 97%, 98% and 99% at the lasing wavelength.

8. The laser of any preceding claim, wherein the lasing wavelength lies in the wavelength range 2 to 20 micrometers.

9. The laser of any preceding claim, wherein the concentric rings of the grating structure (28; 28, 29) and the disk-shaped side surface (33) are at least approximately concentric with each other.

10. The laser of any preceding claim, wherein the higher order grating portion (28) is of order *m* = 2.

11. The laser of any preceding claim, wherein the grating structure (28; 28, 29) is formed by a refractive index contrast in a horizontal plane between portions of the upper or lower cladding layer (14, 16) in which it is formed and one of an adjacent: metal layer (22); degenerately doped semiconductor layer; air; dielectric material; and further layer (40) of semiconductor material.

12. The laser of claim 11, wherein the further layer (40) is arranged at an interface of, or embedded within, the upper cladding layer (16).

13. The laser of any of claims 1 to 12, wherein the plurality of active region layers (15) form a superlattice structure configured to provide gain through intraband transitions between quantum well subbands, thereby forming a quantum cascade laser.

14. The laser of any of claims 1 to 12, wherein the plurality of active region layers (15) form a superlattice structure configured to provide gain through interband transitions between quantum well subbands, thereby forming an interband cascade laser.

15. A method of manufacturing a cascade laser (10) configured to emit laser light at a lasing wavelength, A, the method comprising:
forming an epitaxial semiconductor layer structure comprising in sequence a lower cladding layer (14), a plurality of active region layers (15) to provide gain and an upper cladding layer (16), which layers (14, 15, 16) collectively form an in-plane waveguide;
defining with an etch process a disk-shaped side surface (33) which laterally bounds the in-plane waveguide;
depositing a mirror layer (39) over the disk-shaped side surface (33), the mirror layer (39) and disk-shaped side surface (33) being shaped and dimensioned to form a cavity for the in-plane waveguide which supports multiple radial modes; and
forming a grating structure (28; 28, 29) of concentric rings in one of the upper and lower cladding layers (14, 16), the grating structure including at least a higher order grating portion (28) of order *m ≥ 2* and serving both to select at least one of the multiple radial modes for lasing and to couple out the laser light through at least one of the lower and upper cladding layers (15, 16).
